# FASCICULE DE BREVET EUROPEEN

(11) **EP 0 554 188 B1**
(45) Date de publication et mention de la délivrance du brevet: **22.07.1998**
(21) Numéro de dépôt: 93420018.9
(22) Date de dépôt: 19.01.1993
(51) Int. Cl.: G01R 21/133, G01R 19/25, G01R 19/00

(54) **Dispositif de mesure de grandeurs électriques**
Gerät zur Messung elektrischer Grössen
Device for measuring electrical variables

(30) Priorité: 27.01.1992 FR 9200924
(43) Date de publication de la demande: 04.08.1993
(73) Titulaire: SCHNEIDER ELECTRIC SA, 92100 Boulogne Billancourt (FR)
(72) Inventeur: Ferrazzi, Marc, F-38050 Grenoble Cedex 9 (FR); Kobilsek, Alain, F-38050 Grenoble Cedex 9 (FR); Tommassi, Armand, F-38050 Grenoble Cedex 9 (FR); Bimler, Trevor, F-38050 Grenoble Cedex 9 (FR)
(74) Mandataire: Jouvray, Marie-Andrée

(56) Documents cités:
- EP-A- 0 014 038
- EP-A- 0 332 881
- DE-A- 2 454 601
- US-A- 4 388 611
- US-A- 4 672 555
- IEEE INSTRUMENTATION AND MEASUREMENT TECHNOLOGY CONFERENCE, 27 avril 1989, pages 98-102, Washington, DC; D.J. TURNELL et al.: "A microprocessor-based three phase power transducer"

## Description

L'invention concerne un dispositif selon le préambule de la revendication 1.

Dans de tels dispositifs classiques de traitement numérique de grandeurs électriques, notamment pour le calcul de leur valeur efficace, l'intégration des échantillons de sortie du convertisseur analogique-numérique est réalisée sur un nombre fixe, prédéterminé, d'échantillons (US-A-4.672.555). Lorsque la période d'intégration correspond à un nombre entier de périodes de la grandeur mesurée, la précision de la mesure dépend essentiellement de la précision des moyens analogiques de mesure, de la précision du convertisseur analogique-numérique, de la période d'échantillonnage et du nombre d'échantillons pris en compte pendant la période d'intégration.

Lorsque la période d'intégration ne correspond pas à un nombre entier de périodes de la grandeur à mesurer, ceci introduit une erreur qui peut être importante. A titre d'exemple, on peut montrer que l'erreur commise sur la valeur efficace d'une grandeur dont les échantillons sont intégrés sur 1,125 période au lieu d'une période est de l'ordre de 4 %.

Selon l'invention, cet inconvénient est écarté par un dispositif selon la revendication 1.

De cette manière, la précision de la mesure est maintenue même lorsque la fréquence fondamentale du réseau est différente de sa valeur théorique ou lorsqu'elle varie. De plus, l'appareil peut s'adapter automatiquement à des réseaux de fréquences différentes (50-60 Hz) sans perte de précision.

Selon un développement de l'invention, les moyens analogiques de mesure mesurent au moins une tension du réseau, les premiers moyens comportant des moyens de détection des passages à zéro de la dite tension, la période d'intégration étant délimitée par deux passages à zéro séparés par un nombre prédéterminé, impair, de passages à zéro.

Dans un mode particulier de réalisation, les moyens de détection des passages à zéro comportent un comparateur dont une entrée reçoit la dite tension et dont la sortie fournit un signal carré ayant une première valeur prédéterminée pendant les alternances positives de la tension et une seconde valeur prédéterminée pendant les alternances négatives de la tension.

D'autres avantages et caractéristiques ressortiront plus clairement de l'exposé qui va suivre d'un mode de réalisation particulier de l'invention, donné à titre d'exemple non limitatif et représenté aux dessins annexés sur lesquels :
La figure 1 illustre, sous forme de schéma-bloc, un dispositif de mesure dans lequel l'invention peut être mise en oeuvre,
La figure 2 représente un mode particulier de réalisation du circuit de traitement analogique des tensions du dispositif de la figure 1.
La figure 3 représente un mode particulier de réalisation du circuit de traitement analogique des courants du dispositif de la figure 1.

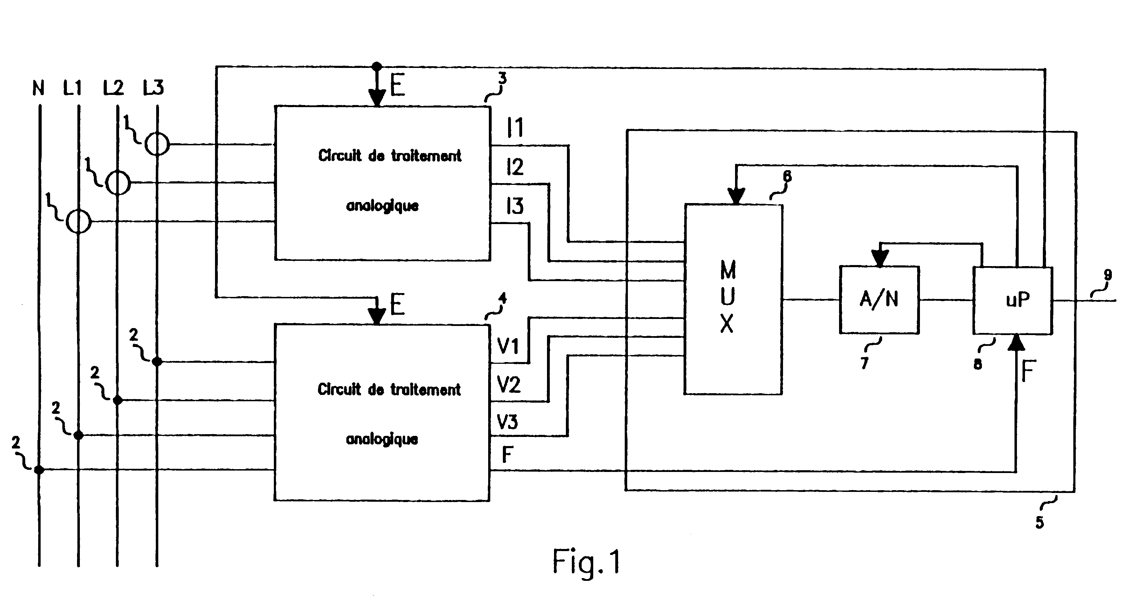

Le dispositif de mesure selon la figure 1 comporte des capteurs de courant 1 permettant de mesurer les courants circulant dans des conducteurs de phase L1, L2 et L3 d'un réseau électrique triphasé. Les tensions du réseau sont prélevées par des capteurs de tension 2 sur les conducteurs de phase L1, L2 et L3 ainsi que sur le conducteur de neutre N du réseau.

Les signaux de sortie des capteurs de courant 1 sont appliqués à des entrées d'un circuit 3 de traitement analogique des courants. Les signaux de sortie des capteurs de tension 2 sont appliqués à des entrées d'un circuit 4 de traitement analogique des tensions. Le circuit 3 fournit, sur trois sorties parallèles, des échantillons analogiques respectivement représentatifs des courants I1, I2 et I3 parcourant respectivement les conducteurs de phase L1, L2 et L3. Le circuit 4 fournit sur trois sorties parallèles des échantillons analogiques respectivement représentatif des tensions V1, V2 et V3 mesurées respectivement entre le conducteur de neutre N et l'un des conducteurs de phase L1, L2 et L3.

Le circuit 4 fournit de plus un signal F représentatif de la fréquence fondamentale du réseau, obtenu à partir de l'un des signaux de tension appliqué à l'entrée du circuit 4.

Les signaux de sortie de circuits 3 et 4 sont appliqués à des entrées d'un circuit de traitement numérique 5. Sur la figure 1, celui-ci est représenté sous forme schématique et comporte un multiplexeur 6, un convertisseur analogique-numérique 7 et un microprocesseur 8.

Les signaux I1, I2, I3, V1, V2 et V3 sont appliqués en parallèle sur les entrées du multiplexeur 6, dont la sortie est connectée à l'entrée du convertisseur 7. Le microprocesseur 8 reçoit séquentiellement du convertisseur 7 des valeurs numériques représentatives des différentes grandeurs mesurées. Dans un mode de réalisation préférentiel, le microprocesseur 8 est un microprocesseur 16 bits et le convertisseur 7 un convertisseur 10 bits. Bien entendu, le convertisseur, et éventuellement le multiplexeur, peuvent être incorporés avec le microprocesseur dans un microcontrôleur.

Le microprocesseur traite les données numériques qui lui sont fournies et calcule différentes grandeurs représentatives du réseau, notamment :
- Les valeurs efficaces des courants I1, I2 et I3.
- Les valeurs efficaces des tensions V1, V2 et V3,
- Les valeurs efficaces des tensions entre phases,
- La fréquence fondamentale F du réseau,
- La puissance active,
- La puissance réactive,
- L'énergie active consommée,
- L'énergie réactive consommée,
- Le facteur de puissance.

Le microprocesseur peut transmettre les grandeurs calculées sur une liaison série 9. Le calcul de ces différentes grandeurs est réalisé à partir des échantillons numériques des signaux de courant et de tension qui sont fournis par le convertisseur 7. L'échantillonnage est réalisé simultanément dans les circuits 3 et 4 sous le contrôle d'un signal de commande d'échantillonnage E fourni par le microprocesseur 8. La période d'échantillonnage est fixe, de l'ordre de 250 microsecondes dans un mode de réalisation préférentiel.

Les différentes grandeurs sont obtenues à partir d'un certain nombre d'échantillons. Les valeurs efficaces des courants ou des tensions sont obtenues par intégration, sur la période d'intégration, du carré d'échantillons de courant ou de tension. Les puissances et les énergies sont obtenues par intégration, sur la période d'intégration, du produit d'échantillons de courant et de tension.

Ainsi, avant chaque calcul, le microprocesseur met en mémoire, dans une mémoire vive associée, le nombre d'échantillons nécessaires au calcul, fournis pas les circuits 3 et 4 pendant la période d'intégration.

La période d'intégration, et en conséquence le nombre d'échantillons pris en compte pour le calcul d'une grandeur, sont, selon l'invention, fonction de la fréquence fondamentale du réseau de manière à ce que la période d'intégration corresponde à un nombre entier de périodes du réseau.

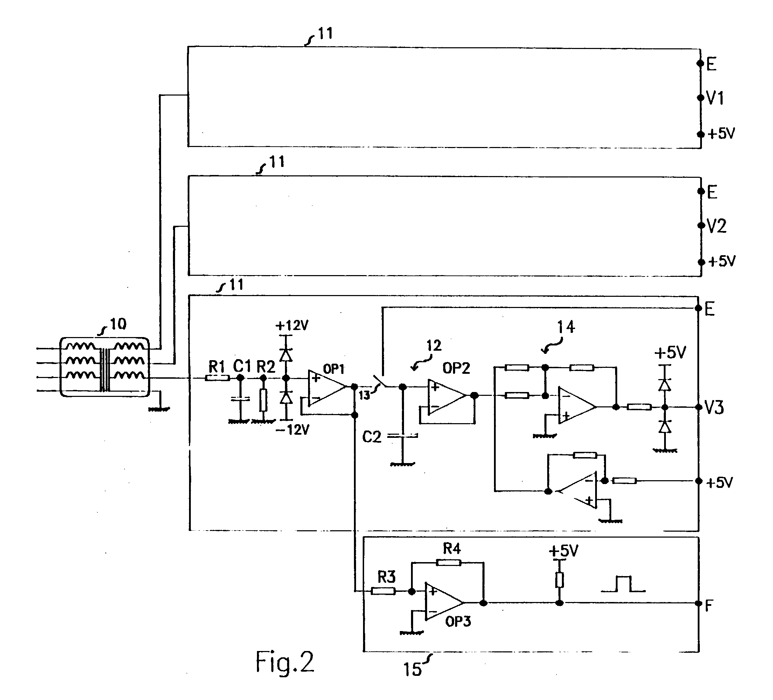

Sur la figure 2, le circuit de traitement analogique des tensions comporte un transformateur 10 dont les entrées sont connectées aux capteurs de tension 2. Dans le mode de réalisation préférentiel représenté, le transformateur 10 est un transformateur triphasé à couplage étoile-étoile. Le point commun des enroulements primaires est connecté au neutre du réseau, ou en l'absence de celui-ci est laissé flottant. Le point commun des enroulements secondaires est connecté à la masse, les autres extrêmités des enroulements secondaires étant respectivement connectées à des circuits 11 de mise en forme et d'échantillonnage des signaux de tension. Sur la figure, seul l'un des circuits 11 est représenté en détail, les deux autres étant identiques.

Le signal d'entrée du circuit 11 est filtré (R1, C1, R2) avant d'être appliqué, par l'intermédiaire d'un adaptateur d'impédance constitué par un amplificateur opérationnel OP1, à l'entrée d'un échantillonneur-bloqueur 12. Sur la figure, celui-ci est constitué par un interrupteur 13 commandé par le signal E et dont la sortie est appliquée aux bornes d'un condensateur C2 et à l'entrée d'un amplificateur opérationnel OP2 servant d'adaptateur d'impédance. Dans le mode de réalisation représenté, le signal de sortie de l'échantillonneur bloqueur 12 peut prendre des valeurs négatives. Il est par conséquent mis en forme (14) de manière à être compris dans des valeurs (0 à 5 V) acceptables par le circuit de traitement numérique 5. On obtient ainsi en sortie du circuit 11 des échantillons analogiques V3 représentatifs du signal d'entrée du circuit 11.

Les échantillons analogiques V1 et V2 sont de même, obtenus en sortie des deux autres circuits 11.

Le circuit de la figure 2 comporte également un circuit 15 de mesure de la fréquence fondamentale du réseau. Ce circuit 15 est connecté à la sortie de l'amplificateur opérationnel OP1 de l'un des circuits 11, celui associé au signal V3 sur la figure. Le circuit 15 détecte les passages à zéro de la tension du réseau correspondant à V3. Il comporte un comparateur OP3 dont l'entrée inverseuse est connectée à la masse et dont l'entrée non inverseuse est connectée à la sortie d'OP1 par l'intermédiaire d'une résistance R3 et à la sortie d'OP3 par l'intermédiaire d'une résistance R4. On obtient ainsi en sortie du comparateur, un signal carré F, nul lorsque le signal d'entrée est négatif, et au niveau logique 1 lorsque le signal d'entrée est positif. La période séparant deux fronts positifs ou deux fronts négatifs du signal F correspond à la période de la tension correspondant à V3. Ce signal F est appliqué sur une entrée de microprocessseur 8 (fig. 1) de manière à définir la période d'intégration des signaux.

Selon un mode de réalisation préférentiel, le microprocesseur 8 utilise les fronts positifs du signal F. Un premier front positif définit le début de la période d'intégration. Tous les échantillons fournis par les circuits de traitement analogique 3 et 4 à partir de ce moment là sont successivement mis en mémoire dans une mémoire vive associée au microprocesseur. Le comptage d'un nombre entier prédéterminé de périodes, c'est-à-dire le comptage d'un nombre prédéterminé, par exemple 8, de fronts positifs du signal F, définit la fin de la période d'intégration. Le microprocesseur calcule alors les grandeurs à mesurer à partir des échantillons mis en mémoire pendant la période d'intégration.

Pour obtenir la fréquence du réseau en utilisant les passages à zéro d'un signal, seuls les signaux représentaifs des tensions du réseau peuvent être utilisés. En effet, les courants peuvent, dans certaines installations, présenter des taux d'harmoniques supérieurs à 100 %, ce qui peut fausser la mesure car dans ce cas, il peut y avoir plusieurs passages à zéro par demi-période. Par contre, en ce qui concerne les tensions du réseau, les taux d'harmoniques ne peuvent dépasser 8 % et le risque est minimum.

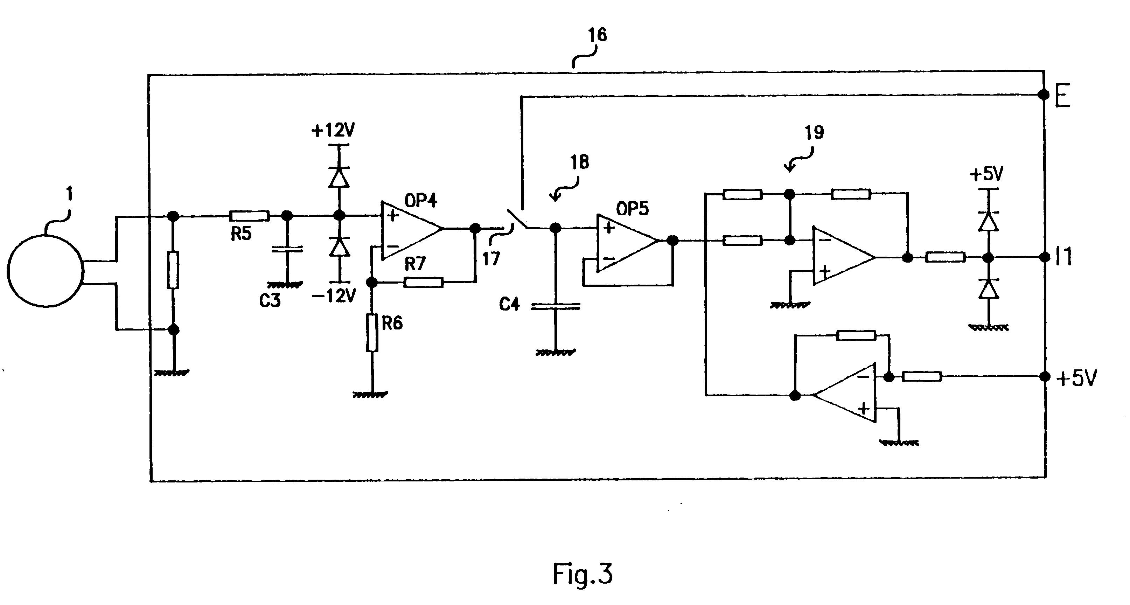

Sur la figure 3, le signal de sortie d'un capteur de courant 1, constitué par un tore, est appliqué à l'entrée d'un circuit 16 de mise en forme et d'échantillonnage d'un signal de courant. Un circuit 16 est associé à chacun des capteurs de courant de manière à fournir des échantillons analogiques 11, 12 ou 13 représentatifs du courant mesuré par le capteur de courant. Sur la figure 3, seul l'un des circuits 16 est représenté.

Le signal d'entrée du circuit 16 est filtré (R5, C3), puis amplifié (OP4, R6, R7), échantillonné par un échantillonneur-bloqueur 18 (interrupteur 17, condensateur C4, OP5) et mis en forme (19). Le gain de l'amplificateur (OP4, R6, R7) peut éventuellement être modifié sous le contrôle du microprocesseur.

L'invention n'est pas limitée en mode de réalisation particulier décrit et représenté en référence aux figures ci-dessus. C'est ainsi notamment que la période d'intégration, tout en restant égale à un nombre entier de périodes du réseau, peut être variable, éventuellement différente selon le type de grandeur à mesurer.

A titre d'exemple non limitatif, le dispositif selon l'invention a permis d'obtenir une précision satisfaisante pour des réseaux dont la fréquence fondamentale est comprise entre 45 Hz et 65 Hz, la période d'échantillonnage étant de 250 microsecondes et la période d'intégration correspondant à 8 périodes du réseau.

## Revendications

1. Dispositif de mesure de grandeurs électriques d'un réseau électrique alternatif de fréquence fondamentale donnée, dispositif comportant des moyens (1,2) analogiques de mesure d'au moins une grandeur du réseau, des moyens (12, 18) d'échantillonnage connectés à la sortie des moyens analogiques de mesure de manière à fournir, avec une période d'échantillonnage fixe, prédéterminée, des échantillons représentatifs des signaux de sortie des moyens analogiques de mesure, des moyens (7) de conversion analogique-numérique connectés à la sortie des moyens d'échantillonnage, et des moyens (8) de traitement numérique effectuant le calcul des grandeurs à mesurer à partir d'une pluralité d'échantillons obtenus sur une période d'intégration et des premiers moyens (15) pour mesurer la fréquence fondamentale du réseau et la période du réseau correspondante, dispositif caractérisé en ce qu'il comporte des seconds moyens (8) pour définir la période d'intégration en fonction de ladite fréquence, de manière à ce que la période d'intégration soit égale à un nombre entier de périodes du réseau.

2. Dispositif selon la reventidation 1, caractérisé en ce que les moyens analogiques de mesure mesurent au moins une tension du réseau, les premiers moyens comportant des moyens (15) de détection des passages à zéro de ladite tension, la période d'intégration étant délimitée par deux passages à zéro séparés par un nombre prédéterminé, impair, de passages à zéro.

3. Dispositif selon la revendication 2, caractérisé en ce que les moyens (15) de détection des passages à zéro comportent un comparateur (OP3, R3, R4) dont une entrée reçoit ladite tension et dont la sortie fournit un signal carré (F) ayant une première valeur prédéterminée pendant les alternances positives de la tension et une seconde valeur prédéterminée pendant les alternances négatives de la tension.

4. Dispositif selon l'une des revendications 2 et 3, caractérisé en ce que les moyens de traitement numérique comportent un microprocesseur (8) connecté à la sortie des moyens (7) de conversion analogique-numérique et à la sortie des moyens (15) de détection des passages à zéro.

5. Dispositif selon l'une quelconque des revendications 2 à 4, caractérisé en ce que ladite tension est la tension mesurée entre un conducteur de phase (L3) et le neutre (N) du réseau.

6. Dispositif selon l'une quelconque des revendications 1 à 5, caractérisé en ce que les moyens analogiques de mesure comportent des moyens (2) fournissant des signaux représentatifs des tensions du réseau.

7. Dispositif selon l'une quelconque des revendications 1 à 6, caractérisé en ce que les moyens analogiques de mesure comportent des moyens (1) fournissant des signaux représentatifs des courants parcourant le réseau.

8. Dispositif selon l'une quelconque des revendications 1 à 7 caractérisé en ce que les grandeurs à mesurer comportent les valeurs efficaces des courants et tensions du réseau.

9. Dispositif selon l'une quelconque des revendications 1 à 8, caractérisé en ce que les grandeurs à mesurer comportent la puissance active, la puissance réactive, l'énergie active consommée, l'énergie réactive consommée, et/ou le facteur de puissance du réseau.

10. Dispositif selon l'une quelconque des revendications 1 à 9, caractérisé en ce que les moyens (12,18) d'échantillonnage échantillonnent simultanément tous les signaux analogiques de sortie des moyens analogiques de mesure (1,2).

## Patentansprüche

1. Anordnung zur Messung elektrischer Größen eines elektrischen Wechselspannungsnetzes mit gegebener Grundfrequenz, welche Anordnung analoge Mittel (1, 2) zur Messung mindestens einer Netzgröße, an den Ausgang der analogen Meßmittel angeschlossene Abtastmittel (12, 18), die dazu dienen, bei festgelegter, konstanter Tastzeit die Ausgangssignale der analogen Meßmittel abbildende Abtastwerte zu liefern, an den Ausgang der Abtastmittel angeschlossene Mittel (7) zur Analog-Digital-Umsetzung und Mittel (8) zur digitalen Verarbeitung, welche die Berechnung der zu messenden Größen auf der Grundlage mehrerer, über eine Integrationszeit aufgenommenen Abtastwerte durchführen, sowie erste Mittel (15) zur Messung der Grundfrequenz und der entsprechenden Periodendauer des Netzes umfaßt, dadurch gekennzeichnet, daß die Anordnung zweite Mittel (8) zur Definition der Integrationszeit in Abhängigkeit von der genannten Frequenz umfaßt, so daß die Integrationszeit einer ganzzahligen Anzahl von Perioden des Netzes entspricht.

2. Anordnung nach Anspruch 1, dadurch gekennzeichnet, daß die analogen Meßmittel mindestens eine Spannung des Netzes messen, wobei die genannten ersten Mittel Mittel (15) zur Erfassung der Nulldurchgänge der genannten Spannung umfassen und die Integrationszeit durch zwei Nulldurchgänge begrenzt wird, zwischen denen eine bestimmte, ungerade Anzahl von Nulldurchgängen liegt.

3. Anordnung nach Anspruch 2, dadurch gekennzeichnet, daß die Mittel (15) zur Erfassung der Nulldurchgänge einen Komparator (OP3, R3, R4) umfassen, dessen einer Eingang mit der genannten Spannung beaufschlagt wird und dessen Ausgang ein Rechtecksignal (F) liefert, das während der positiven Halbwellen der Spannung einen bestimmten ersten Wert und während der negativen Halbwellen der Spannung einen bestimmten zweiten Wert führt.

4. Anordnung nach einem der Ansprüche 2 und 3, dadurch gekennzeichnet, daß die Digitalverarbeitungsmittel einen, an den Ausgang der Mittel (7) zur Analog-Digital-Umsetzung sowie an den Ausgang der Mittel (15) zur Erfassung der Nulldurchgänge angeschlossenen Mikroprozessor (8) umfassen.

5. Anordnung nach irgendeinem der Ansprüche 2 bis 4, dadurch gekennzeichnet, daß die genannte Spannung der zwischen einem Phasenleiter (L3) und dem Neutralleiter (N) des Netzes gemessenen Spannung entspricht.

6. Anordnung nach irgendeinem der Ansprüche 1 bis 5, dadurch gekennzeichnet, daß die analogen Meßmittel Mittel (2) umfassen, welche die Spannungen des Netzes abbildende Signale liefern.

7. Anordnung nach irgendeinem der Ansprüche 1 bis 6, dadurch gekennzeichnet, daß die analogen Meßmittel Mittel (1) umfassen, welche die Ströme des Netzes abbildende Signale liefern.

8. Anordnung nach irgendeinem der Ansprüche 1 bis 7, dadurch gekennzeichnet, daß die zu messenden Größen die Effektivwerte der Spannungen und Ströme des Netzes umfassen.

9. Anordnung nach irgendeinem der Ansprüche 1 bis 8, dadurch gekennzeichnet, daß die zu messenden Größen die Wirkleistung, die Blindleistung, den Wirkverbrauch, den Blindverbrauch und/oder den Leistungsfaktor umfassen.

10. Anordnung nach irgendeinem der Ansprüche 1 bis 9, dadurch gekennzeichnet, daß die Abtastmittel (12, 18) sämtliche, am Ausgang der analogen Meßmittel (1, 2) zur Verfügung gestellten analogen Signale gleichzeitig abtasten.

## Claims

1. A device for measuring electrical quantities of an AC electrical power system of given fundamental frequency, a device comprising analog means (1, 2) for measuring at least one quantity of the power system, sampling means (12, 18) connected to the output of the analog means for measuring so as to supply, with a predetermined fixed sampling period, samples representative of the output signals of the analog means for measuring, means (7) for analog to digital conversion connected to the output of the sampling means, and digital processing means (8) performing calculation of the quantities to be measured from a plurality of samples obtained over an integration period and first means (15) for measuring the fundamental frequency of the power system and the corresponding period of the power system, a device characterized in that it comprises second means (8) for defining the integration period according to said frequency so that the integration period is equal to an integral number of periods of the power system.

2. The device according to claim 1, characterized in that the analog means for measuring measure at least one voltage of the power system, the first means comprising means (15) for detecting the moments when said voltage passes zero, the integration period being bounded by two passages at zero separated by a predetermined, odd, number of passages at zero.

3. The device according to claim 2, characterized in that the means (15) for detecting the passages of the voltage at zero comprise a comparator (OP3, R3, R4) an input of which receives said voltage and the output of which supplies a square signal (F) having a first predetermined value during the positive half-waves of the voltage and a second predetermined value during the negative half-waves of the voltage.

4. The device according to either one of the claims 2 and 3, characterized in that the means for digital processing comprise a microprocessor (8) connected to the output of the means (7) for analog-to-digital conversion and to the output of the means (15) for detecting the passages at zero.

5. The device according to any one of the claims 2 to 4, characterized in that said voltage is the voltage measured between a phase conductor (L3) and the neutral (N) of the power system.

6. The device according to any one of the claims 1 to 5, characterized in that the analog means for measuring comprise means (2) supplying signals representative of the voltages of the power system.

7. The device according to any one of the claims 1 to 6, characterized in that the analog means for measuring comprise means (1) supplying signals representative of the currents flowing in the power system.

8. The device according to any one of the claims 1 to 7, characterized in that the quantities to be measured comprise the rms values of the currents and voltages of the power system.

9. The device according to any one of the claims 1 to 8, characterized in that the quantities to be measured comprise the active power, the reactive power, the active energy consumed, the reactive energy consumed, and/or the power factor of the power system.

10. The device according to any one of the claims 1 to 9, characterized in that the sampling means (12, 18) simultaneously sample all the analog output signals from the analog means for measuring (1, 2).
